# EUROPÄISCHE PATENTANMELDUNG

(11) **EP 3 130 990 A2**
(43) Veröffentlichungstag der Anmeldung: **15.02.2017**
(21) Anmeldenummer: 16183767.9
(22) Anmeldetag: 11.08.2016
(51) Int. Cl.: G06F 3/042, H03K 17/945

(54) **BERÜHRUNGLOSE HYGIENISCHE TASTE**

(30) Priorität: 11.08.2015 DE 202015005702 U
(71) Anmelder: Pohl, Wolfgang, 14167 Berlin (DE)
(72) Erfinder: Pohl, Wolfgang, 14167 Berlin (DE)
(74) Vertreter: Hertin und Partner Rechts- und Patentanwälte PartG mbB

(57) **Zusammenfassung**

Die Erfindung betrifft eine Eingabevorrichtung zur berührungslosen Bedienung eines Tastenfeldes, wobei mit Hilfe eines Paares aus Sender und Empfänger für Licht und/oder Ultraschall eine Detektionsschranke geformt wird, sodass die Positionierung einer Hand bevorzugt eines Fingers vor mindestens einer Taste des Tastenfeldes berührungslos bestimmbar ist.

## Beschreibung

Die Erfindung betrifft eine Eingabevorrichtung zur berührungslosen Bedienung eines Tastenfeldes, wobei mit Hilfe eines Paares aus Sender und Empfänger für Licht und/oder Ultraschall eine Detektionsschranke geformt wird, sodass die Positionierung einer Hand bevorzugt eines Fingers vor mindestens einer Taste des Tastenfeldes berührungslos bestimmbar ist.

### HINTERGRUND UND STAND DER TECHNIK

Das Gebiet der Erfindung betrifft die Eingabemöglichkeit zur Bedienung verschiedenster Vorrichtungen, welche herkömmlich von Tasten oder Tastenfelder durchgeführt werden. Derartige Eingabevorrichtung sind im täglichen Leben vielfältig anzutreffen. Beispielsweise erfolgt die Bedienung von Fahrstühlen, Getränkeautomaten oder codierten Türöffner oftmals mit Hilfe von Tastenfeldern. Im herkömmlichen Sinne sind Tasten manuell, kontrollierbare Schalter, bei denen die Ausübung eines Druckers mit einem Finger ein elektrisches Signal in einem sich dahinter befindenden Stromkreis bewirkt. Hierdurch kann eine Zustandsänderung der Taste detektiert werden, welche ohne Berührung inaktiv ist und durch die Berührung aktiviert wird. Zur Auslösung der herkömmlichen Tasten ist es mithin notwendig, dass ein Finger physisch die Oberfläche der Taste kontaktiert.

Insbesondere in Bereichen in denen eine Vielzahl von unterschiedlichen Menschen die Tasten bedienen, ist die Berührung geeignet die Tastenoberfläche zu beschmutzen und naturgemäß auch Krankheitskeime auf andere Menschen zu übertragen. Die gesellschaftliche Relevanz sei anhand des Beispiels von Fahrstühlen in Krankenhäusern verdeutlicht. Gerade in Krankenhäuser sind die Anforderungen an Hygienestandards als besonders hoch einzustufen. Zum einen bergen diese Orte naturgemäß ein erhöhtes Potential an Krankheitserregern, zum anderen sind gerade auch immuneschwache Patienten besonders vor einer Ansteckung zu schützen. Die immense Bedeutung einer Eindämmung der Verbreitung von Krankheitskeimen innerhalb von Krankenhäuser zeigt sich insbesondere auch an dem erhöhten Auftreten multi-resistenter Keime, sowohl bei dem Krankhauspersonal als auch bei den Patienten. Ein Desinfektion sämtlicher potentiell keimbelasteter Oberflächen ist daher eine zwingende Aufgabe und bei ordnungsgemäßer Durchführung mit hohen Kosten verbunden. Es wäre daher wünschenswert, wenn eine Eingabevorrichtung bereitgestellt werden kann, welche die hygienischen Risiken minimiert. Die Entwicklung eines hygienischen Tastenfeldes wäre jedoch nicht nur vorteilhaft in diesem Kontext, sondern selbstverständlich ebenfalls in anderen privaten, öffentlichen und geschäftlichen Räumen. Gerade an frequentierten öffentlichen Orten, man denke beispielsweise an Zugangstüren zu öffentlichen Toiletten Klingeltasten oder die Tasten eines Aufzugs, kommt es durch die berührungsbehaftete Bedienung herkömmlichen Tasten es zu einer vermehrten Ausbreitung von Krankheitserregern.

Im Stand der Technik werden keine technischen Lösungen zur Umsetzung von hygienischen Tasteneingabevorrichtungen vorgeschlagen. Es existieren zwar Ansätze und Lösungen für berührungslose Bedienungsinterfaces für die Mensch-Maschinen-Interaktion. Diese sind jedoch entweder zu komplex, teuer oder fehleranfällig. Zum Beispiel beschreibt die US 8933876 B2 ein dreidimensionales Bedienungsinterface, welches auf einer optischen Erkennung von Handbewegungen basiert. Der Sensor zur dreidimensionalen Detektion der Handbewegung ist eine Kamera, welche an einen Computer angeschlossen ist. Basierend auf den aufgenommen Bilddaten können mit Hilfe einer Bildanalyse die Handzeichen registriert werden und Aktionen auslösen. Die offenbarte, berührungslose Erkennung und Eingabevorrichtung ist jedoch aufwendig sowohl in Bezug auf die benötigen Gerätschaften, als auch die notwendige Prozessorleistung. Somit sind derartige Ansätze zur Entwicklung einer berührungslosen Eingabevorrichtung für Fahrstühle, Türzugänge oder dergleichen unter dem Kostenaspekt und der Bedienungssicherheit nicht geeignet.

### AUFGABE DER ERFINDUNG

Eine Aufgabe der Erfindung war es die Nachteile des bekannten Standes der Technik zu beseitigen und eine Eingabevorrichtung bereitzustellen, welche durch eine berührungslose Bedienung hohen hygienischen Standards genügt und sich durch einen technisch einfachen, robusten und kostengünstigen Aufbau auszeichnet.

### ZUSAMMENFASSUNG DER ERFINDUNG

Erfindungsgemäß wird die Aufgabe durch die unabhängigen Ansprüche gelöst. Die abhängigen Patentansprüche stellen bevorzugte Ausführungsformen der erfindungsgemäßen Vorrichtung sowie der erfindungsgemäßen Verwendung dar.

Die Erfindung betrifft bevorzugt eine Eingabevorrichtung zur berührungslosen Bedienung eines Tastenfeldes umfassend eine Datenverarbeitungsvorrichtung, mindestens einen Sender zur Ausstrahlung von Licht und/oder Ultraschall, mindestens einen Empfänger zur Detektion von Licht- und/oder Ultraschall und ein Tastenfeld mit mindestens einer Taste, wobei die Eingabevorrichtung dadurch gekennzeichnet ist, dass das mindestens eine Paar aus Sender und Empfänger eine Detektionsschranke formt und Daten der Sender und Empfänger durch die Datenverarbeitungsvorrichtung auswertbar sind, sodass anhand der Daten eine Positionierung einer Hand bevorzugt eines Fingers vor mindestens einer Taste des Tastenfeldes bestimmbar ist.

Im Sinne der Erfindung bezeichnet ein Tastenfeld mit mindestens einer Taste bevorzugt nicht die vorhergehend für den Stand der Technik beschriebenen herkömmlichen Tasten, welche mithilfe einer physischen Interaktion durch Ausübung eines mechanischen Druckes bedient werden. Stattdessen wird im Sinne der Erfindung bevorzugt unter einem Tastenfeld oder einer Taste eine jegliche visuelle Markierung verstanden, welche zur Anzeige einer Position und/oder Funktion einer herkömmlichen Taste geeignet ist. In einem einfachen Fall kann beispielsweise eine Taste des Tastenfeldes die zeichnerische Darstellung einer Zahl, eventuell gerahmt mit einem Kasten sein. Es kann auch sein, dass eine Taste lediglich durch visuell erkennbare Sender oder Empfänger gekennzeichnet wird. Es ist bevorzugt, dass die Taste im Sinne der Erfindung einem Benutzer anzeigt, an welcher Position im Raum eine Hand bevorzugt ein Finger durch eine berührungslose Eingabe eine bestimmte Aktion auslösen kann. Beispielsweise entspräche für die berührungslose Bedienung eines Fahrstuhls ein bevorzugtes Tastenfeld einer visuellen Markierung der einzelnen Stockwerke.

Die Sender und Empfänger bilden im Sinne der Erfindung bevorzugt Detektionsschranken. Im Sinne der Erfindung bezeichnet eine Detektionsschranke bevorzugt ein Paar aus einem Sender und einem Empfänger. Der Sender ist bevorzugt eine Vorrichtung, welche geeignet ist Licht oder Ultraschall abzustrahlen, und der Empfänger ist bevorzugt eine Vorrichtung, welche die vom Sender emittierte Strahlung detektierten kann. Im Sinne der Erfindung meint der Begriff Strahlung bevorzugt Licht oder Ultraschall. Beide Vorrichtungen sind bevorzugt automatisch steuerbar und können Daten an eine Datenverarbeitungsvorrichtung übermitteln. Für den Sender sind bevorzugte Daten die Intensität oder Frequenz der emittierten Strahlung. Vom Empfänger generierte Daten umfassen hingegen bevorzugt eine quantitative Messung der einfallenden Strahlung beispielsweise der Intensität, welche als elektronische Signale der Datenverarbeitungsvorrichtung zur Auswertung bereitgestellt werden. Die Datenverarbeitungsvorrichtung ist bevorzugt ein Mikrochip, Mikrocontroller oder eine integrierte Schaltung (engl. *integrated circuit* IC). Für die geformte Detektionsschranke erlaubt die Auswertbarkeit der Daten des Paares aus Sender und Empfänger vorteilhafterweise die Feststellung, ob ein Objekt wie beispielsweise ein Finger die Detektionsschranke passiert. Dabei kann es bevorzugt sein, dass die Detektionsschranke lediglich eine Aussage darüber treffen kann, ob eine Hand bevorzugt ein Finger in selbige eingeführt wurde. Es kann aber auch bevorzugt sein, dass die Detektionsschranke eine örtliche Auflösung der Positionierung einer Hand bevorzugt eines Fingers innerhalb der Detektionsschranke erlaubt. In einer bevorzugten Ausführungsform kann die Detektionsschranke eine Durchgangsschranke sein. Hierbei befinden sich der Sender und der Empfänger auf bevorzugt gegenüberliegenden Seiten einer Taste. Der Sender emittiert bevorzugt das Licht oder aber den Ultraschall entlang eines definierten Strahlenganges, welcher sich vor der Taste befindet. Im Falle, dass sich kein Finger in dem Strahlengang befindet, wird der Empfänger die emittierte Strahlung detektieren. Sollte jedoch eine Hand bevorzugt ein Finger den Strahlengang der Detektionsschranke kreuzen, so wird dieser blockiert. Die Positionierung einer Hand bevorzugt eines Fingers kann aufgrund der Blockade als ein abnehmendes Signal erkannt werden. In einer weiteren bevorzugten Ausführungsform ist die Detektionsschranken eine Reflex-Tastschranke. Im Falle einer Reflex-Tastschranke sind der Sender und der Empfänger bevorzugt auf derselben Seite einer Taste angeordnet, wobei ein Strahlengang vor der Taste erzeugt wird. Befindet sich kein Finger oder Objekt im Strahlengang der Reflex-Tastschranke, so wird am Empfänger bis auf ein Grundrauschen bevorzugt kein Signal detektiert. Falls jedoch ein Finger in die Reflex-Tastschranke gehalten wird, so wird die vom Sender emittierte Strahlung zum Empfänger reflektiert. Eine Positionierung einer Hand bevorzugt eines Fingers in der Reflex-Tastschranke ist daher bevorzugt durch ein zunehmendes Detektionssignal am Empfänger registrierbar.

Es ist bevorzugt, dass unter der Registrierung der Positionierung einer Hand bevorzugt eines Fingers ebenso verstanden wird, dass die Eingabevorrichtung bevorzugt die Positionierung anderer Objekte wie beispielsweise eine Stift oder einen Zeiger erkennt. Es ist besonders bevorzugt, dass die Dimensionierung der Tasten des Tastenfeldes sowie der Detektionsschranken auf die berührungslose Eingabe mit einem Finger optimiert ist. Es kann aber auch bevorzugt sein, dass die Eingabevorrichtung derart dimensioniert wird, dass beispielsweise eine berührungslose Eingabe mit einer Handfläche erfolgen kann.

Die Detektionsschranke kann bevorzugt durch verschiedene Arten von Strahlungen gebildet werden, welche eine berührungslose Detektion von der Positionierung eines Fingers ermöglichen. Besonders bevorzugte Strahlungen entsprechen Licht oder Ultraschall. Im Sinne der Erfindung wird unter Licht jegliche elektromagnetische Strahlung verstanden, welche bevorzugt einen Wellenlängenbereich zwischen 300 nm und 1500 nm aufweist. Dem entsprechend wird unter Licht im Sinne der Erfindung nicht nur elektromagnetische Strahlung verstanden, welche im sichtbaren Bereich, d.h. in einem Wellenlängenbereich zwischen 380 nm und 780 nm emittiert wird. Stattdessen kann mit Licht bevorzugt auch infrarotes Licht mit einer Wellenlänge zwischen 780 nm und 1500 nm verstanden werden. Besonders bevorzugte Wellenlängenbereiche für die erfindungsgemäßen Detektionsschranken entsprechen rotem Licht im Bereich von 540 nm - 560 nm oder infrarotem Licht im Bereich von 850 nm - 900 nm. Für diese Wellenlängenbereiche liegt ein besonders gutes Signal-zu-Rauschverhältnis vor.

Neben der elektromagnetischen Strahlung sind auch andere Strahlungsformen für die Detektionsschranken gemäß der Erfindung geeignet. Bevorzugt sollte die Strahlungsform dahingehend ausgewählt werden, dass ein Objekt wie der menschliche Finger eine Perturbation der Strahlung auslöst, welche eine besonders präzise und robuste Detektion der Positionierung des Fingers erlaubt. Weiterhin sollte die Strahlung bevorzugt Gesundheitsrisiken für den Menschen minimieren und mit geringem Energieaufwand betreibbar sein. Eine weitere besonders bevorzugte Strahlung, welche neben der Infrarotstrahlung diese Kriterien erfüllt ist Ultraschall. Unter Ultraschall wird bevorzugt Schall mit einer Frequenz oberhalb des hörbaren Frequenzbereiches des Menschen verstanden. Bevorzugte Ultraschall-Frequenzen liegen zwischen 20 kHz und 10 MHz, bevorzugt zwischen 20 kHz und 1 MHz. Auch Ultraschall ist bevorzugt geeignet, um Detektionsschranken zu formen, welche im Sinne der Erfindung eine berührungslose Bedienung erlauben.

Für die Erfindung war es völlig überraschend, dass mithilfe von derart einfachen konstruktiven Elementen Detektionsschranken gebildet werden können, welche eine präzise, robuste und schnelle Detektion der Positionierung eines Fingers vor einer Taste eines Tastenfeldes berührungslos ermöglichen.

Im Sinne der Erfindung wird unter der Bezeichnung "vor einer Taste" eine Positionierung in einem durch die visuelle Markierung der Taste eingrenzbaren Raum verstanden, welcher bevorzugt einen Raum senkrecht zur Tastenoberfläche in einem festlegbaren Abstand meint. Für eine Detektionsschranke entspricht beispielsweise bevorzugt "vor der Taste" einen Abstand von bevorzugt weniger als 5 cm. Die Bezeichnung "vor der Taste" stellt bevorzugt lediglich eine Zuordenbarkeit des durch die Detektionsschranke abtastbaren Raumes zu einer Taste dar. Sollte beispielsweise das Tastenfeld auf dem Boden installiert sein, so wird unter einem "vor der Taste" auch ein entsprechendes oberhalb oder über der Taste verstanden. Falls die Taste an einer Fläche oder Wand angezeigt wird, meint das "vor der Taste" beispielsweise bevorzugt den senkrechten Raum vor der markierten Taste auf der Wand, wobei ein Abstand von der Wand festlegbar sein kann. Der Abstand richtet sich bevorzugt danach wie dicht ein Finger in die Nähe der Taste gebracht werden sollte, um ein Signal auszulösen.

Der Fachmann versteht die Koordinationsangabe "vor der Taste" somit als eine Koordinatenangabe, welche zur Erzeugung eines virtuellen, berührungslosen Tastenfeldes mit Hilfe der Detektionsschranken vor - d.h. in der Luft - dem visuell markierten Tastenfeld erlaubt.

In einer bevorzugten Ausführungsform der Erfindung ist die Eingabevorrichtung dadurch gekennzeichnet, dass der mindestens eine Sender ein Infrarotsender ist und der mindestens eine Empfänger ein Fototransistor. Es ist besonders bevorzugt, dass der Infrarotsender eine Infrarot-LED ist, wobei das Infrarot-Licht bevorzugt mit einer Pulsfrequenz abgestrahlt. Durch Festlegung einer Pulsfrequenz ist es vorteilhafterweise eine besonders spezifische Detektion des von dem Senders emittierten Infrarotlichtes möglich. So kann Licht, welches nicht mit der vom Sender emittierten Frequenz auf den Empfänger fällt, auf einfache Weise als Störsignal erkannt werden. Fehldetektionen durch Infrarotlicht aus der Umgebung zum Beispiel von einer Fernbedienung können somit besonders wirksam vermieden werden. Ein gepulster Infrarotsender erlaubt somit Fehler und Störungen der Detektionsschranke besonders wirksam zu vermeiden. Der Fototransistor ist in dieser bevorzugten Ausführungsform bevorzugt ein Halbleiterbauelement, welches auf die Detektion des gepulsten Infrarotsenders optimiert ist und einfallende Infrarot-Photonen in ein elektrisches Signal umwandelt. Es ist bevorzugt, dass der Fototransistor besonders sensitiv im Infrarotbereich ist und ein besonders gutes Signal-zu-Rauschverhältnis aufweist.

Infrarot-LEDs können bevorzugt in verschiedenen Ausführungen zum Einsatz kommen. Diese reichen von kleinen SMD-Modulen (*surface mounted devices* mit Abmessungen von wenigen Zentimetern z.B. (1 x 3 cm)) bis hin zu Größen von einigen Dezimetern. Die Wellenlänge der bevorzugten Strahlung liegt im Bereich von 860 - 1040 nm. Es kann jedoch auch rotes Licht besonders bevorzugt mit einer Wellenlänge von ungefähr 550 nm eingesetzt werden. Im Sinne der Erfindung wird mit den Bezeichnungen "nahezu, ungefähr", "ca." oder ähnlichen Ausdrücken bevorzugt eine Toleranzspanne von ±10% bevorzugt von ±5% bezogen auf den genannten Wert verstanden. Hierdurch sind besonders gute Größenauflösung der Fingerbreiten möglich.

Beispielhaft soll auf verschiedene auf Infrarotlicht basierte Detektionsschranken als bevorzugte Ausführungsformen eingegangen werden. So sind für Nahmessungen SMD-Bauteile besonders vorteilhaft, da bei diesen Sender und Empfänger bereits in einem gemeinsamen Gehäuse und auf einem Carrier eingebaut sind. Diese lassen sich somit schnell und einfach in eine Halterung integrieren. Bevorzugte Detektionsschranken sind digital über mehrere Kontakte ansteuerbar und können ein Objekt in einem Bereich unter 5 cm registrieren. Weitere bevorzugte Detektionsschranken erlauben eine Detektion in einer Distanz bis zu 10 cm oder 15 cm. Tests haben ergeben, dass der Erfassungsbereich für einen menschlichen Finger auf einer Halbkugel mit einem Radius von ca. 2,5 cm liegt für eine 5 cm-Variante und einen Radius von ca. 5,5 cm aufweist für die 10 cm-Variante. Für einzelne Tasten sind 10 cm-Varianten bevorzugt. Bei einer Anordnung mehrere Tasten ist es bevorzugt einen Abstand zwischen den Detektionsschranken zu lassen, um Fehldetektionen zu vermeiden. Tests haben ergeben, dass ein Abstand von bevorzugt 6 - 8 cm, bevorzugt von ca. 6,8 cm zwischen den Mitten zweier Detektionsschranken gute Ergebnisse liefert. Der Fachmann weiß, wie er Reflex-Tastschranken mit den bevorzugten Eigenschaften konstruieren kann. Bevorzugte Reflex-Tastschranken können auch kommerziell erworben werden. Beispielhaft ist das Modell GP2Y0D805Z0F von Sharp für die erfindungsgemäße Eingabevorrichtung eine besonders vorteilhafte Infrarot-Detektionsschranke.

Weiterhin kann es bevorzugt sein eine Infrarot-Detektionsschranke einzusetzen, welche eine Entfernungsmessung erlaubt. D.h. es ist bevorzugt Infrarot-Detektionsschranken bevorzugt als Reflex-Tastschranke einzusetzen, welche den Abstand eines eingeführten Fingers von dem Paar aus Sender und Empfänger bestimmen kann. Bevorzugt erfolgt hierzu eine gepulste Abstrahlung des Infrarotlichtes und eine Entfernungsmessung durch eine direkte Zeitmessung zwischen Sendesignal und empfangenen, reflektiertem Signal, wobei eine interne Auswertung mit Hilfe der Datenverarbeitungsvorrichtung erfolgt. Beispielsweise kann die Ansteuerung einer Infrarot-LED über ein I²C-Interface erfolgen, wobei als Datenverarbeitungsvorrichtung ein Mikrocontroller zum Einsatz kommt. Bevorzugt kann sowohl Infrarotes-Licht von 780 nm bis 1500 nm, aber auch rotes Licht insbesondere mit einer Wellenlänge zwischen 520 nm und 580 nm, bevorzugt ungefähr 550 nm benutzt werden. Der Fachmann weiß, wie er Reflex-Tastschranken mit den bevorzugt genannten Eigenschaften konstruieren kann. Bevorzugte Reflex-Tastschranken können auch kommerziell erworben werden. Zum Beispiel sei das Modell VL6180X von STMicroelectronics als besonders vorteilhafte Infrarot-Detektionsschranke genannt, welche eine Entfernungsmessung durchführen kann.

Weiterhin kann es bevorzugt sein, die Strahlungswege der Infrarot-Sender und Infrarot-Empfänger durch den Einsatz von entsprechenden optischen Glasfasern an die Gegebenheiten der technischen Umgebung anzupassen.

In einer bevorzugten Ausführungsform der Erfindung ist die Eingabevorrichtung dadurch gekennzeichnet, dass der Sender ein Ultraschallsender ist und der Empfänger ein Ultraschalldetektor. Überraschenderweise hat sich gezeigt, dass auch durch die Verwendung eines Ultraschallsenders und -empfängers eine hochsensitive Detektionsschranke geformt werden kann. Zum einen zeichnet sich die Verwendung von Ultraschall durch eine geringe Anfälligkeit gegenüber Störungen aus. Weiterhin erlaubt der Ultraschall nicht nur eine besonderes präzise Messung eines Fingers in einer Detektionsschranke, sondern zudem eine hohe örtliche Auflösung der Positionierung des Fingers beispielsweise im Falle einer Reflex-Tastschranke.

Zur Entfernungsmessung eines Fingers in der Ultraschall-Reflextastschranke kann bevorzugt ein gepulster Ultraschallsender eingesetzt werden. Hierbei erfolgt eine Entfernungsmessung durch Detektion der Zeitdifferenz zwischen Pulsbeginn und Detektion des Reflexes. Die Auswertung kann mit Hilfe der Datenverarbeitungsvorrichtung zum Beispiel mit Hilfe eines Mikrocontrollers erfolgen. Bevorzugte Pulsbreiten liegen zum Beispiel zwischen 20 und 150 µs, wodurch vorteilhafterweise bis zu 50 Messungen pro Sekunden möglich werden. Der Fachmann weiß, wie er Reflex-Tastschranken mit den bevorzugt genannten Eigenschaften konstruieren kann. Bevorzugte Reflex-Tastschranken auf Basis von Ultraschall können auch kommerziell erworben werden. Zum Beispiel sei das Modell HC-SR04 von ACME Systems als besonders vorteilhafte Ultraschall-Detektionsschranke genannt, welche eine Entfernungsmessung durchführen kann.

Ein solches Prinzip der Abstandsmessung mit Hilfe von Ultraschallsendern und - empfängern wird im Stand der Technik zum Beispiel bei Kraftfahrzeugen an der hinteren Stoßstange durchgeführt.

Besonders bevorzugt können Ultraschallsender mit einer Frequenz zwischen 10 kHz und 100 kHz bevorzugt zwischen 30 kHz und 50 kHz verwandt werden. Bevorzugt sind Sender und Empfänger getrennte Bauteile. Es wäre aber auch möglich, dass die Sender und Empfänger ein Bauteil darstellen, welches zwischen den verschiedenen Funktionen als Sender und als Empfänger umschalten kann. Hierzu müsste nach dem Senden des Ultraschalles auf Empfang gestellt werden, d.h. der Sender würde von der Funktion eines Lautsprechers auf die Funktion eines Mikrophons umgeschaltet werden. Eine solche Vorgehensweise kommt im Falle der Abstandsmessung bei Stoßstangen zum Tragen.

Bevorzugt kommen Ultraschall-Sender zum Einsatz, welche eine Flächenleistung von weniger als 50 mW/cm² aufweisen. Vorteilhafterweise werden hierdurch Gesundheitskrisen minimiert. Bei Ultraschallfrequenzen von 200 kHz bis 500 kHz und Reichweiten von über 1 m kann es zu Flächenleistungen von über 1000 mW/cm² kommen. Solche Leistungen können biologisch negative Folgen bei einer Dauerbenutzung haben. In dem Fall wäre es daher bevorzugt durch eine Strom- oder Spannungsbegrenzung oder aber einer Vergrößerung der durchstrahlten Fläche mit Hilfe eines Diffusors die Flächenleistung auf unterhalb einer bevorzugten Grenze von 50 mW/cm² zu bringen.

In einer bevorzugten Ausführungsform der Erfindung umfasst die Eingabevorrichtung eine optische Anzeige bevorzugt eine LED, welche den Betätigungszustand der Taste anzeigt. Durch die Aufnahme einer optischen Anzeige, bevorzugt einer LED Anzeige, ist es möglich auf einfache Weise dem Benutzer anzuzeigen, ob die Eingabevorrichtung eine berührungslose Eingabe korrekt interpretiert hat. Zu diesem Zweck kann die optische Anzeige bevorzugt zweifarbig konfiguriert sein. Beispielsweise kann die optische Anzeige zunächst rot leuchten, solange die Taste durch eine berührungslose Bedienung nicht aktiviert wurde. Bei einer Positionierung des Fingers vor einer Taste, sodass durch eine Pertubation des Strahlenganges eine Aktivierung der Taste ausgelöst wird, erfolgt bevorzugt Übergang der optischen Anzeige von rot auf grün. Es hat sich gezeigt, dass durch ein derartiges optisches Feedbacksystem eine besonders bedienungsfreundliche Umsetzung möglich ist, da die berührungslose Bedienung durch den Nutzer präziser erfolgt.

In einer bevorzugten Ausführungsform der Erfindung ist die Eingabevorrichtung dadurch gekennzeichnet, dass ein Paar aus Sender und Empfänger in einer Taste des Tastenfeldes nebeneinander angeordnet vorliegt und die Emission des Lichtes oder des Ultraschalls senkrecht zur Tastenoberfläche erfolgt, wobei bei einer Positionierung eines Fingers vor der Taste das vom Sender emittierte Licht oder der vom Sender emittierte Ultraschall zum Empfänger zurückreflektiert wird, sodass das Paar aus Sender und Empfänger eine Reflex-Tastschranke bildet. Diese bevorzugte Ausführungsform betrifft eine sogenannte Reflex-Tastschranke, welche durch das Paar aus Sender und Empfänger gebildet wird und innerhalb der Taste vorliegt. Innerhalb der Taste bedeutet, wie anhand der erfindungsgemäß definierten Taste ersichtlich ist, bevorzugt, dass das Paar aus Sender und Empfänger an einer bestimmten visuellen markierten Position installiert vorliegt. Beispielsweise kann dies ein durch ein Kästchen angedeuteter Bereich sein. Es kann aber auch sein, dass sichtbare Empfänger oder Sender selbst die Taste bilden, da auch diese eine visuelle Markierung darstellen können.

Durch die senkrechte Abstrahlung des Lichtes oder des Ultraschalles in den Raum vor der Taste ist es möglich eine Annäherung einer Hand bevorzugt eines Fingers besonders genau und mit hoher Sicherheit zu detektieren. So ist im Falle, dass sich kein Finger oder Objekt vor der Taste sich befindet, bei dem Empfänger lediglich ein Grundrauschen als Signal festzustellen. Sobald jedoch eine Hand bevorzugt ein Finger sich der Taste nähert, wird das Licht oder der Ultraschall zurückreflektiert. Durch die Reflexion an dem physischen Objekt erreicht eine erhöhte Reflexionsstrahlung den Empfänger, welcher ein erhöhtes Signal detektiert und somit eine Aktivierung der Taste veranlasst.

Diese Konzeption einer Detektionsschranke, welche auf Basis eines reflektierten Signales funktioniert, wird auch als Reflex-Tastschranke bezeichnet. Überraschenderweise hat sich eine bevorzugte Reflex-Tastschranke, welche innerhalb einer Taste installiert vorliegt, als besonders zuverlässig herausgestellt, da lediglich Fingerbewegungen, welche senkrecht vor der Taste stattfinden, erkannt werden. Ein Finger, welcher sich beispielsweise seitlich rechts oder links einer Taste annähert, löst zunächst vorteilhafterweise kein Aktivierung der Taste aus, bis dieser senkrecht in den vorgegebenen Erfassungsbereich des Strahlenganges senkrecht vor der Taste gelangt. Die bevorzugte Ausführungsform wird aufgrund der senkrechten Ausstrahlung zur Tastenoberfläche auch als frontale Reflex-Tastschranke bezeichnet.

Die Tasten können darüber hinaus auch als mehrere Tasten auf einem Tastenfeld angeordnet vorliegen. Beispielsweise kann das Tastenfeld mehrere Tasten umfassen, welche gitterförmig angeordnet sind. In jeder der Tasten kann bevorzugt ein Paar von Sender und Empfänger vorliegen, durch welche eine Positionierung des Fingers vor der jeweiligen Taste sicher, präzise und schnell registriert wird. Somit können durch diese einfache technische Gestaltung auch berührungslose Eingaben auf komplexen Tastenfeldern umgesetzt werden.

In einer bevorzugten Ausführungsform der Erfindung ist die Eingabevorrichtung dadurch gekennzeichnet, dass die Reflex-Tastschranke eine senkrechte Positionierung eines Fingers vor der Taste unterhalb eines festgelegten Abstandes, bevorzugt unterhalb eines Abstandes zwischen 2 cm bis 10 cm, besonders bevorzugt zwischen 3 cm bis 5 cm, detektiert. In dieser bevorzugten Ausführungsform wird durch die Datenverarbeitungsvorrichtung bevorzugt eine Detektionsschwelle des reflektierten Signales am Empfänger gewählt, welche sicherstellt, dass ein Finger erst ab einem Abstand von bevorzugt weniger als 10 cm besonders bevorzugt weniger als 5 cm eine berührungslose Eingabe auslöst. Tests haben gezeigt, dass der gewählte Abstand besonders nutzerfreundlich ist und Fehleingaben vermeidet. Weiterhin wird durch die genannte untere Schwelle der bevorzugten Abstände von 2 cm, und besonders bevorzugt 3 cm ein ungewolltes Berühren des Paares aus Sender und Empfänger durch den Finger verhindert, da eine Auslösung frühzeitig erfolgt.

In einer weiteren bevorzugten Ausführungsform der Erfindung umfasst die Eingabevorrichtung mindestens eine Halterung zur Aufnahme des mindestens einen Senders und mindestens einen Empfängers, wobei das mindestens eine Paar aus Sender und Empfänger in der Halterung nebeneinander positioniert ist, sodass das Licht oder der Ultraschall von dem Sender in einem Strahl parallel zur Oberfläche der mindestens eine Taste mittig vor der mindestens eine Taste abgestrahlt wird, wobei bei einer Positionierung einer Hand bevorzugt eines Fingers vor der mindestens einen Taste das vom Sender abgestrahlte Licht oder der Ultraschall zum Empfänger zurückreflektiert wird und die Datenverarbeitungsvorrichtung anhand der Daten die Entfernung des Fingers von dem mindestens einen Paar aus Sender und Empfänger messen ermitteln kann, sodass auf dieser Basis die gebildete Reflex-Tastschranke durch eine Entfernungsmessung eine Positionierung der Hand bevorzugt des Fingers vor der mindestens einen Taste bestimmbar ist.

Eine weitere bevorzugte Ausführungsform stellt eine alternative Bauweise einer Reflex- Tastschranke als Detektionsschranke dar. Hierbei erfolgt der Strahlengang nicht wie im vorherigen Fall senkrecht zur Oberfläche der Taste, sondern parallel vor der Taste. Zu diesem Zweck ist das Paar aus Sender und Empfänger bevorzugt derart in einer Halterung positioniert, dass diese jeweils seitlich oder ober- und unterhalb der Taste angeordnet vorliegen. Der Sender emittiert bevorzugt die Strahlung in Richtung vor der Taste in einem parallelen Abstand zur Taste. Der parallele Abstand des Strahlenganges der Reflex-Tastschranke kann bevorzugt in einem Bereich zwischen 0,2 cm und 10 cm besonders bevorzugt in einem Bereich zwischen 1 cm und 5 cm erfolgen.

Auch in dieser Bauweise einer Reflex-Tastschranke, erfolgt die Detektion einer Positionierung einer Hand bevorzugt eines Fingers vor der Taste auf Basis der von einer Hand bevorzugt von einem Finger reflektierten Strahlung. Es ist dabei besonders bevorzugt, dass auf Basis des reflektierten Signales, d.h. bevorzugt auf Basis der Intensität der reflektierten Strahlung, die Datenverarbeitungsvorrichtung bestimmen kann, in welcher Entfernung von dem Paar aus Sender und Empfänger eine Hand bevorzugt ein Finger in die derart gebildete Reflex-Tastschranke eingeführt wurde. Zur Bestimmung der Entfernung auf Basis des reflektierten Signales können verschiedene Prinzipien erfindungsgemäß umgesetzt werden. So kann beispielsweise eine gepulste Abstrahlung durch den Sender erfolgen und auf Basis einer Laufzeitmessung die Entfernung des Fingers vom Sender-Empfänger-Paar berechnet werden. Auch kann es bevorzugt sein, dass mehrere Sender oder Empfänger verwandt werden, sodass mithilfe einer Triangulation eine Entfernungsmessung anhand des gemessenen Winkeleinfalles der reflektierten Strahlung erfolgt. Es ist bevorzugt, dass die Auflösung der Entfernungsmessung es erlaubt, dass mithilfe der Reflex-Tastschranke ermittelt werden kann, ob der Finger sich direkt vor der Taste befindet oder vor oder hinter der Taste entlang des Strahlenganges. Vorteilhafterweise kann durch eine Festlegung von Schwellengrenzen für die Entfernungswerte eine gewünschte Toleranz für eine berührungslose Eingabe vorgegeben werden.

Im Sinne der Erfindung bezeichnet eine Halterung bevorzugt jeglicher Art einer Vorrichtung, welche zur Aufnahme eines Senders oder eines Empfängers geeignet ist. Beispielsweise kann die Halterung eine Winkelform aufweisen, welche mit einer Seite an einer Wand oder einer anderen stabilen Stellfläche befestigt wird und die andere Seite eine feste Positionierung des Senders und des Empfängers gegenüber der Taste erlaubt. Der Begriff der Halterung bezeichnet bevorzugt die funktionelle Eigenschaft einer solchen Vorrichtung, wodurch diese für einen Fachmann definiert wird. Es kann bevorzugt sein, dass die Halterung aus einem Stück gefertigt ist und sowohl den Sender, als auch den Empfänger aufnimmt. Es kann aber auch bevorzugt sein, dass zwei Stücke oder Teile als eine Halterung fungieren und separat zu Positionierung je eines Senders und eines Empfängers eingesetzt werden. Dies ist insbesondere bevorzugt der Fall, wenn der Sender und der Empfänger auf gegenüberliegenden Seiten angeordnet werden. Auch können in einer Halterung, welche aus einem oder mehreren Teilen besteht, mehrere Sender und/oder Empfänger installiert werden.

In einer bevorzugten Ausführungsform der Erfindung umfasst das Tastenfeld mehrere Tasten, welche in mindestens einer Reihe entlang der Orientierung mindestens einer Reflex-Tastschranke angeordnet vorliegen, wobei durch die Entfernungsmessung mit Hilfe der Reflex-Tastschranke bestimmbar ist, vor welcher der mehreren Tasten ein Finger positioniert wird. Unter dem Begriff der Reihe wird bevorzugt verstanden, dass die Tasten linear entlang des Strahlenganges der Detektionsschranke angeordnet vorliegen. Der Begriff der Reihe ist bevorzugt nicht auf eine Orientierung im Raum eingeschränkt. So kann auf den Raum bezogen mit dem Begriff einer Reihe sowohl eine senkrechte als auch eine waagerechte Orientierung der Tasten linear hintereinander als aber auch eine Orientierung der Tasten linear hintereinander entlang einer beliebigen diagonalen Richtung verstanden werden. Der Fachmann erkennt, dass die Aneinanderreihung der Tasten in einer Reihe auf einer Linie durch die Ausbreitungsrichtung der Strahlung, beispielsweise des Lichtes oder des Ultraschalles festgelegt wird. Durch eine mittige Positionierung des Strahlenganges vor der Tastenreihe wird sichergestellt, dass die Reflex-Tastschranke eine Registrierung eines Fingers entlang der Tastenreihe ermöglicht. Vorteilhafterweise kann durch eine Entfernungsmessung einer Hand bevorzugt eines Fingers von dem Paar des Senders oder Empfängers präzise ermittelt werden, über welcher Taste der Reihe die Hand bevorzugt der Finger in die Reflex-Tastschranke eingebracht wurde. Die Auflösung der Entfernungsmessung durch die Reflex-Tastschranke beträgt bevorzugt mindestens den halben Abstand zwischen zwei Tasten, sodass eine zuverlässige Separation von Eingabeaktionen für verschiedene Tasten erfolgt.

Es war überraschend, dass mithilfe einer derart einfachen Vorrichtung bereits ein komplexeres Tastenfeld aus mehreren Tasten entlang einer Linie zuverlässig, sicher und robust berührungslos bedient werden kann. Eine solche Anordnung kann beispielsweise bevorzugt zur Bedienung eines Fahrstuhls eingesetzt werden. Hierbei kann die Reihe der angeordneten Tasten den einzelnen Stockwerken entsprechen. Zur Nutzung einer Entfernungsmessung mithilfe einer Reflex-Tastschranke ist es bevorzugt, dass der Sender ein Ultraschallsender ist und der Empfänger ein Ultraschalldetektor. Es kann auch bevorzugt sein, dass der Sender eine gepulste Infrarotdiode und der Empfänger ein Fototransistor ist. Die Genauigkeit der Entfernungsbestimmung ist bevorzugt unterhalb von 2 cm besonders bevorzugt unterhalb von 0,2 cm. Überraschenderweise reichen bereits diese Auflösungsgrenzen aus, um eine Vielzahl von verschiedenen Tastenfeldkonfigurationen durch die berührungslose Reflex-Tastschranke zu erfassen. Die geringen technischen Anforderungen an die einzelnen Bauelemente der Eingabevorrichtung unterstreichen die vorteilhafte Konstruktionsweise und erlauben eine kostengünstige Herstellung und einen extrem fehlerarmen Betrieb.

In einer weiteren bevorzugten Ausführungsform der Erfindung ist die Eingabevorrichtung dadurch gekennzeichnet, dass das Tastenfeld mehrere Tasten umfasst, welche in mindestens zwei Reihen angeordnet vorliegen, wobei für jede der mindestens zwei Reihen jeweils ein Paar aus Sender und Empfänger eine Reflex- Tastschranke bilden, um auf Basis einer Entfernungsmessung die Positionierung einer Hand bevorzugt eines Fingers vor genau einer Taste des Tastenfeldes zu bestimmen. In dieser bevorzugten Ausführungsform wird ein Tastenfeld, welches gitterförmig angeordnet ist, durch eine entsprechende Anzahl von Reflex-Tastschranken abgedeckt. Hierzu ist es bevorzugt, dass die Halterung derart positioniert ist, dass die Paare aus Sender und Empfänger jeweils mittig zu den einzelnen Reihen der Tasten angeordnet vorliegen, sodass der Strahlengang der Reflex-Tastschranke mittig oberhalb der Reihe der Tasten erfolgt. Es war überraschend, dass mit derart einfachen technischen Mitteln ein gitterförmiges, komplexes Tastenfeld berührungslos bedient werden kann. Hierzu ist lediglich pro Reihe ein Paar aus Sender und Empfänger nötig, wobei durch die Entfernungsmessung eine Gitterdetektion ermöglicht wird.

Ein bevorzugtes gitterförmiges Tastenfeld kann beispielsweise drei Reihen umfassen, mit jeweils 4 Tasten, wobei in bekannter Weise die Zahlen 0-9 sowie optional ein Sternzeichen oder Rautezeichen als visuelle Markierung vorliegen, um ein Ziffernblatt zu markieren. Hierdurch kann berührungslos ein Zifferncode eingeben werden, welcher beispielsweise eine Tür öffnet, um einen berührungslosen Zugang zu einem Raum oder einem Gebäude zu ermöglichen.

In einer bevorzugten Ausführungsform der Erfindung umfasst die Eingabevorrichtung mindestens eine Halterung zur Aufnahme des mindestens einen Senders und mindestens einen Empfängers, wobei das mindestens eine Paar aus Sender und Empfänger in der Halterung auf zwei gegenüberliegenden Seiten der mindestens einen Taste des Tastenfeldes positioniert ist, sodass das Paar eine Durchgangsschranke bildet, wobei bei einer Positionierung einer Hand bevorzugt eines Fingers vor der mindestens einen Taste der Strahl von Licht oder Ultraschall zwischen dem Sender und Empfänger blockiert wird, sodass eine Positionierung der Hand bevorzugt des Fingers vor der mindestens einen Taste detektiert werden kann.

In dieser bevorzugten Ausführungsform wird durch das Paar aus Sender und Empfänger eine Durchgangsschranke gebildet. Hierzu ist es bevorzugt, dass durch eine Halterung die Sender und Empfänger auf jeweils gegenüberliegenden Seiten der Tasten angeordnet vorliegen. Im Falle, dass kein Finger oder Objekt in die Detektionsschranke eingebracht wird, erfolgt eine konstante Detektion der emittierten Strahlung des Senders. Sobald jedoch ein Finger oder ein Objekt in den Strahlengang der Detektionsschranke gebracht wird, wird vorteilhafterweise der Strahlengang abgelenkt oder blockiert. Hierdurch ist ein signifikanter Abfall der am Empfänger gemessenen Strahlungsintensität zu verzeichnen. Dieses Signal kann von der Datenverarbeitungsvorrichtung als eine berührungslose Eingabe vor der Taste interpretiert werden.

Zum Zweck der Positionierung des Senders und Empfängers auf gegenüberliegenden Seiten der Taste ist bevorzugt eine Halterung vorgesehen. Die Halterung kann sowohl aus einem Stück gefertigt sein, als auch aus zwei separaten Stücken, welche jeweils auf gegenüberliegenden Seite der Taste angebracht vorliegen. Bevorzugt wird durch die Halterung eine mittige Positionierung der Empfänger-Sender-Paare in Bezug auf die Taste erreicht, wodurch ein paralleler Strahlengang vor der Tastenoberfläche erfolgt. Tests haben ergeben, dass ein Abstand des Strahlenganges von 0,2 cm bis 10 cm bevorzugt von 1 cm bis 5 cm eine besonders nutzerfreundliche Bedienung ermöglicht.

In einer bevorzugten Ausführungsform der Erfindung umfasst die Eingabevorrichtung ein Tastenfeld mit mehreren Tasten, welche in mindestens einer Reihe angeordnet vorliegen, wobei Paare aus Sendern und Empfänger derart in einer Halterung seitlich von der Reihe der Tasten positioniert werden, dass vor jeder Taste eine Durchgangsschranke geformt wird, sodass anhand der Daten der Durchgangsschranken bestimmbar ist, vor welcher der mehreren Tasten eine Hand bevorzugt ein Finger positioniert wird. Durch die bevorzugte Ausführungsform ist es möglich, die in einer Reihe oder Linie angeordneten Tasten mithilfe von mehreren Durchgangsschranken wirksam abzudecken. Somit wird eine berührungslose Eingabe spezifisch und zuverlässig für jeweils eine Taste der Reihe registriert. Zur Positionierung der Paare von Sendern und Empfängern und zur Bildung der Detektionsschranken, welche mittig über den jeweiligen Tasten der Reihe angeordnet vorliegen, ist es bevorzugt, dass jeweils eine Halterung parallel zu der Reihe installiert wird. Je nach Ausdehnung der Reihe können die seitlichen Halterungen beispielsweise bevorzugt die Länge der Tastenreihe und eine Höhe von ca. 3 - 5 cm aufweisen.

In einer bevorzugten Ausführungsform der Erfindung umfasst die Eingabevorrichtung ein Tastenfeld mit mehreren Tasten, welche in einem Gitter, umfassend mindestens zwei Reihen und mindestens zwei Spalten, angeordnet vorliegen, wobei mindestens vier Paare von Sendern und Empfänger mindestens vier Durchgangsschranken formen, welche mittig vor den Reihen und Spalten des gitterförmigen Tastenfeldes verlaufen, sodass aus der Korrelation der Daten der Durchgangsschranken bestimmbar ist, vor welcher der Tasten des gitterförmigen Tastenfeldes ein Finger positioniert wird. Durch die bevorzugte Ausführungsform ist es vorteilhafterweise möglich auch ein gitterförmiges Tastenfeld mit Durchgangsschranken effektiv abzudecken und zu überwachen. Durch Korrelation der einzelnen Signale der gitterförmigen Detektionsschranken ist eine robuste und zuverlässige Zuordnung zu den Tasten möglich. So kann beispielsweise ein Tastenfeld vorliegen, welches zwei Spalten und zwei Reihen aufweist. Sollte ein Finger zur oberen linken Ecke des Tastenfeldes geführt werden, so kann die Positionierung anhand einer gleichzeitigen Signaldetektion der Detektionsschranken vor der ersten Reihe und ersten Spalte festgestellt werden. Ein Fachmann erkennt, auf welche Art und Weise durch Korrelation der Detektionsschranken das gesamte Gitter abgedeckt werden kann. Wie obig beschrieben, können derartige gitterförmige Tastenanordnungen beispielsweise zur berührungslosen Eingabe von Zifferncodes genutzt werden.

In einer bevorzugten Ausführungsform der Erfindung ist die Eingabevorrichtung dadurch gekennzeichnet, dass die Datenverarbeitungsvorrichtung einen Mikrocontroller und/oder eine integrierte Schaltung umfasst, sodass eine Ansteuerung entsprechender elektronischer Schalter oder Relais durchgeführt werden kann und Fehlauslösungen detektiert werden. Die Umsetzung einer Datenverarbeitungsvorrichtung mithilfe eines Mikrocontrollers oder aber einer integrierten Schaltung erlaubt durch besonders einfache Bauelemente eine robuste Steuerung und Auswertung der jeweiligen Sender und Empfänger. Weiterhin kann mithilfe des Mikrocontrollers oder der integrierten Schaltung auf besonders robuste Weise Fehlauslösungen erkannt werden. Solche Fehlauslösungen können beispielsweise dadurch registriert werden, dass das detektierte Signal innerhalb von definierten Orts- und Zeitbereichen liegen muss. Es kann aber auch bevorzugt sein, dass eine Fehlauslösung dadurch detektiert wird, dass beispielsweise ein Signal nicht mit der Senderfrequenz am Empfänger detektiert wird. Dies ist insbesondere dann möglich, wenn ein gepulster Sender, beispielsweise ein gepulster Infrarotsender eingesetzt wird.

Als ein bevorzugt verwendbarer Mikrocontroller sei beispielhaft der Mikrocontroller vom Typ Genuino in der Ausführung Genuino nano von der Firma Arduino genannt. In den USA wird der Typ Genuino auch als Arduino bezeichnet. Diese Mikrocontroller wurden zu Lehrzwecken entwickelt und sind vorteilhafterweise zusammen mit OpenSource zugänglichen Programmen nutzbar. Bei dem bevorzugten Mikrocontroller sitzt der gängige Mikroprozessor Atmega128 bereits auf einem kleinen Board, das den direkten Anschluss von 16 digitalen I/O-Leitungen gestattet. Dies ist vorteilhafterweise ausreichend für zum Beispiel fünf Infrarot-Schranken und fünf zugeordneten Relais. Somit können vorteilhafterweise fünf unabhängige berührungslose Tasten angesteuert werden. Die Taktrate dieses bevorzugten Mikroprozessors liegt bei 16 MHz. Da vorteilhafterweise kein Betriebssystem eingesetzt werden muss, um eine Auswertung zu ermöglichen, ist diese Taktrate ausreichend. Für einen erhöhten Bedarf gibt es eine Vielzahl von gleichartigen Prozessoren mit einer Taktrate bis in den GHz-Bereich. Dem Fachmann sind solche Prozessoren beispielsweise aus der Herstellung von Smartphones bekannt. Solche schnelleren Prozessoren können beispielsweise vorteilhaft eingesetzt werden, um eine Vielzahl von Tasten eines Tastenfeldes mit einem verfügbaren Real-Time-Betriebssystem anzusteuern.

Bevorzugt liegt auf dem Mikrocontroller ein Software-Programm zur Ansteuerung und Auswertung der mindestens einen Detektionsschranke vor. Beispielsweise kann das Programm über einen Loader, d.h. ein Programm zum Laden des Programms, in den Speicher geschrieben werden. Danach wird das Programm gestartet und ausgeführt, solange eine Stromversorgung der Eingabevorrichtung erfolgt. Die Stromversorgung des bevorzugten Mikrocontrollers ist besonders einfach, wenn dieser selbst eine Spannungsregelung besitzt. Vorteilhafterweise kann in dem Fall eine 230V∼ Netzspannung über ein einfaches Netzteil an den bevorzugten Mikrocontroller z.B. den Arduino und über diesen die Sender/Empfänger angeschlossen werden. Auch entsprechend angesteuerte Relais lassen sich problemlos bei einem bevorzugt direkten Anschluss betreiben.

Um eine berührungslose Taste zu betreiben, ist es bevorzugt eine Gleichstromversorgung in einem Bereich von 3 bis 9 V einzusetzen. Liegt die angelegte Versorgungsspannung über 5,7 V, so erzeugt ein bevorzugter Mikrocontroller eine geregelte Spannung mit mindestens 4,7 V mit der nahezu alle Digitalchips versorgt werden können.

Um eine Infrarot-Detektionsschranke zu realisieren, ist es bevorzugt eine Input-Leitung zu überwachen, mit deren Auswertung eine Output-Leitung zu einem Relais ansteuerbar ist. Bevorzugt läuft das Programm zur Steuerung und Auswertung der Infrarot-Detektionsschranke in einer Schleife.

Weiterhin ist es bevorzugt in die Ausführung des Programmes Zeitschleifen einzubauen, um Fehldetektionen zu vermeiden. Hierdurch kann vorteilhafterweise ein Auslösen durch einen kurzen Kontakt durch schnelle Bewegungen vor dem Sensor vermieden werden. So kann beispielsweise verhindert werden, dass ein Finger auf dem Weg zur eigentlichen Taste bereits ein Fehlsignal auslöst. Eine zeitliche Auswertung des Signales bevorzugt mit einem Mikrocontroller erlaubt daher eine besonders präzise, schnelle und zuverlässige Detektion.

Wird die Positionierung des Fingers über längere Zeit gehalten, so wird dies erkannt und verarbeitet. Beispielsweise könnte dies über ein Alarmlampe angezeigt werden oder das Relais kann wieder ausgeschaltet werden. Durch diese Möglichkeiten lässt sich die Eingabevorrichtung vorteilhafterweise auf verschiedene Anwendungsfälle optimieren.

Beispielhaft sei die Bedienung der Ruftasten eines Fahrstuhls genannt. Hierbei kann es bevorzugt sein zwei berührungslose Tasten einzubauen, wobei auf einen hinreichenden Abstand zu achten ist. Über einen Aufsatz auf ein konventionelles Tastenfeld ließe sich zum Beispiel die erfindungsgemäße Eingabevorrichtung auch nachträglich anbringen. Bevorzugt wird eine zu kurze Auslösung nicht erkannt und nicht berücksichtigt. Nur eine korrekte Auslösung, beispielsweise ab einer Mindestverweildauer von 500 ms oder 1 Sekunde in einem festlegbaren Zeitbereich beispielsweise von 100 bis 1000 ms bewirkt die Umschaltung eines Relais, das in die Signalleitung der Steuervorrichtung des Aufzugs eingebunden ist. Die Kontroll-Lampe der jeweiligen Taste wird von der Steuervorrichtung des Aufzuges geschaltet. Das Relais wird gleichzeitig zurückgeschaltet. In analoger Weise könnten auch die konventionellen Tastenfelder der Aufzugskabine durch die erfindungsgemäße Eingabevorrichtung ersetzt werden. Hierbei ist es bevorzugt die Hardware auf die Anzahl der Tasten anzupassen.

Weiterhin kann der Mikrocontroller bevorzugt eingesetzt werden, um eine Ultra-Schall-Detektionsschranke zu steuern und auswerten. Hierzu erfolgt bevorzugt eine Überwachung einer Input-Leitung zur Anzeige einer Positionierung eines Fingers. Dies erfolgt bevorzugt nachdem über eine Output-Leitung der Ultraschall-Sender angesteuert wird und einen kurzen Impuls aussendet. Es ist bevorzugt, dass die Laufzeit des Signals gemessen und daraus der Abstand des positionierten Fingers errechnet wird. Kein Vorliegen eines Fingers bedeutet in diesem Falle, dass die maximal mögliche Laufzeit bis zu einer flächigen Begrenzung gemessen wird. Mit der Überwachung dieser Laufzeit können auch unterschiedliche äußere Beeinflussungen erkannt werden. Eine starke dauerhafte Verkürzung der Laufzeit weist auf eine Fehlbedienung hin oder aber den Umstand, dass eine Hand oder ein Gegenstand im Sensorbereich vorliegt. Eine geringe Änderung der maximalen Laufzeit deutet auf eine Temperaturänderung hin. Dies kann aufgrund der Temperaturabhängigkeit der Schallgeschwindigkeit zu leichten Zuordnungsfehlern führen. Daher ist es bevorzugt in der Programmierung des Mikrocontrollers eine automatische Temperaturkompensation zu integrieren. Hierdurch kann eine besonders zuverlässige Erkennung umgesetzt werden, welche sich an Veränderungen der Umgebung anpasst. Weiterhin ist es bevorzugt im Falle einer parallelen Detektionsschranke, welche senkrecht vor den Tasten eine Hand bevorzugt einen Finger detektiert, einen hinreichenden Abstand der Tasten des Tastenfeldes zu gewährleisten. Ein besonderer Vorteil der Ultraschall-Sensorik liegt im einfachen Aufbau, mit dem mehrere Tasten besonders schnell und zuverlässig erkannt werden könnten. Ein zeitlicher Durchgang für die Messung benötigt bevorzugt ca. 10 ms. Es sind somit vorteilhafterweise bis zu 100 Abtastzyklen pro Sekunde möglich. Für die Auswertung von Fingerbewegungen ist dies vorteilhafterweise ausreichend.

Die Erfindung betrifft weiterhin bevorzugt die Verwendung einer Eingabevorrichtung zur berührungslosen Bedienung einer Taste, eines Schalters, einer Klingeltaste, eines Fahrstuhles, eines Automaten insbesondere eines Automaten zur Ausgabe von Lebensmitteln oder eines Codeschlosses bevorzugt zur Authentifizierung eines Zuganges zu einem Raum oder einem Gebäude. Aufgrund der robusten und sicheren Bauweise der erfindungsgemäßen Eingabevorrichtung ist es vorteilhafterweise möglich, diese für die verschiedensten Anwendungen einzusetzen. So war es besonders überraschend, dass mithilfe einer erfindungsgemäßen Eingabevorrichtung eine besonders leichte und hygienische Bedienung eines Fahrstuhls möglich ist. Hierzu kann beispielsweise eine Tastenreihe für die Stockwerke mit Hilfe von mehreren Durchgangsschranken oder einer entfernungssensitiven Reflex-Tastschranke berührungslos bedient werden. Im Vergleich zu herkömmlichen Tastenfeldern kann durch einfache konstruktive Bauelemente eine Übertragung von Keimen oder Schmutz verhindert werden. Weiteren war es überraschend möglich durch die Erfindung auch für Automaten, wie beispielsweise Automaten zur Ausgabe von Getränken oder Snacks eine keimfreie Bedienung bereitzustellen. Im Stand der Technik ist es üblich, dass Getränke- oder Snackautomaten ein Tastenfeld aufweisen, durch welches mittels der Betätigung von Einzeltasten und Eingabe eines Zahlencodes eine Auswahl erfolgt. Durch die kontaktbehaftete Eingabe steigt das Risiko eine Beschmutzung der Finger unmittelbar vor Einnahme der Lebensmittel. Für herkömmliche Lebensmittelautomaten treten daher Hand-zu-Mund Infektionen gehäuft auf. Überraschenderweise kann durch Verwendung einer erfindungsgemäßen, berührungslosen Eingabevorrichtung derlei wirksam verhindert werden. Weiterhin ist eine überraschend bedienungsfreundliche und sichere Verwendung der berührungslosen Eingabevorrichtung als Codeschloss möglich. Beispielsweise kann die Eingabevorrichtung ein Zahlenfeld als Tastengitter umfassen, wodurch eine berührungslose Eingabe von Zifferncodes möglich ist. In der Verwendung als Tür- oder Toröffner wird eine besonders hygienische Authentifizierung eines Zuganges zu einem Raum oder Gebäude umgesetzt. Derartige berührungslose Türöffner sind besonders vorteilhaft in Krankenhäusern oder aber auch in Forschungsinstituten, insbesondere solchen Instituten, bei denen potentielle Pathogene zu Forschungszwecken verwandt werden. Die berührungslose Eingabe von Zifferncodes ist jedoch nicht nur aus gesundheitlicher Sicht vorteilhaft, sondern erhöht zudem die Sicherheit. So kann bei kontaktbehafteten Codeschlössern anhand von einer vorher aufgebrachten Substanz, z.B. eine Creme, die Tasteneingabe für sichtbar gemacht werden. Diese inhärente Sicherheitslücke kontaktbehafteter Codeschlösser, welche sich Kriminelle zu Nutze machen können, wird durch die erfindungsgemäße Eingabevorrichtung wirksam vermieden.

Im Folgenden soll die Erfindung an Hand von Beispielen näher erläutert werden, ohne auf diese beschränkt zu sein.

### Kurzbeschreibung der Abbildungen

- Abb. 1: Schematische Ansicht einer bevorzugten Eingabevorrichtung umfassend eine einzelne Taste mit einer frontalen Reflex-Tastschranke
- Abb. 2: Schematische Ansicht einer bevorzugten Eingabevorrichtung umfassend eine einzelne Taste mit einer frontalen Reflex-Tastschranke, welche vertieft in einer Wand vorliegt
- Abb. 3: Schematische Ansicht einer bevorzugten Eingabevorrichtung umfassend eine einzelne Taste mit einer frontalen Reflex-Tastschranke, welche von einem Rahmen begrenzt wird
- Abb. 4: Schematische Ansicht einer bevorzugten Eingabevorrichtung wie in Abb. 3 jedoch mit einem schrägen Rahmen umfassend eine einzelne Taste mit einer frontalen Reflex-Tastschranke, welche von einem Rahmen begrenzt wird
- Abb. 5: Schematische Ansicht einer bevorzugten Eingabevorrichtung umfassend eine Detektionsschranke mit hakenförmigen Halterung zur Aufnahme des Empfängers
- Abb. 6: Schematische Ansicht einer bevorzugten Eingabevorrichtung umfassend eine Detektionsschranke, welche in der Ecke einer Wand installiert vorliegt
- Abb. 7: Schematische Ansicht einer bevorzugten Eingabevorrichtung umfassend eine justierbare Halterung zur Aufnahme des Sender-Empfänger-Paares als flexiblem Schlauch
- Abb. 8: Schematische Ansicht einer bevorzugten Eingabevorrichtung mit einer Reihe von Tasten und einer Reflex-Tastschranke, welche basierend auf einer Entfernungsmessung die berührungslose Bedienung der einzelnen Tasten erkennt
- Abb. 9: Schematische Ansicht einer bevorzugten Eingabevorrichtung umfassend ein Tastenfeld mit einer Reihe von Tasten, welche durch jeweils eine Detektionsschranke überwacht werden
- Abb. 10: Schematische Ansicht einer bevorzugten Eingabevorrichtung umfassend ein Tastenfeld mit einem Gitter von Tasten, welche durch ein Gitter von Detektionsschranke überwacht werden.

### Detaillierte Beschreibung der Abbildungen

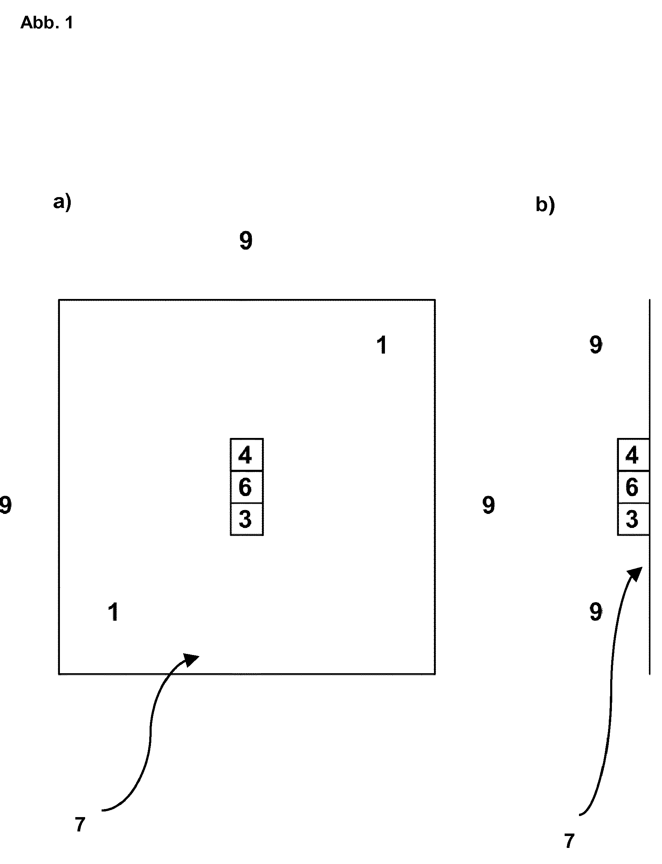

Abb. 1 zeigt eine schematische Ansicht einer bevorzugten Eingabevorrichtung umfassend eine einzelne Taste (7) mit einer frontalen Reflex-Tastschranke, welche in einer Wand (9) installiert vorliegt. Abb. 1a zeigt eine Draufsicht und Abb. 1 b zeigt eine Schnittansicht. Der Sender (4) liegt neben dem Empfänger (6) in der Halterung (1) an oder innerhalb der Wand (9) installiert vor. Bei dem Sender (4) handelt es sich bevorzugt um einen Ultraschall-Sender oder einen Infrarotsender. Der Sender (4) strahlt frontal, senkrecht zur Oberfläche der Taste (7) ab. Die visuelle Markierung als Taste (7) wird durch die visuell sichtbare Umrandung der Halterung (1) und durch die sichtbaren Sender (4), Empfänger (6) und Kontroll-LED (3) gebildet. Wird eine Hand bevorzugt ein Finger in einem Abstand vor die Taste (7), d.h. vor das Paar aus Sender (4) und Empfänger (6) gebracht, so wird die Strahlung zu dem Empfänger (6) zurückreflektiert und die Positionierung der Hand bevorzugt des Fingers löst eine Aktivierung der Taste (7) aus. Die Aktivierung kann zum Beispiel durch einen Farbwechsel der Kontroll-LED (3) visualisiert werden. Die Kontroll-LED (3) zeigt somit bevorzugt den Betriebszustand der Taste (7) an. Aufgrund der frontalen Abstrahlung zur berührungslosen Bedienung einer Taste (7) wird die Ausführungsform der Reflex-Tastschranken auch als frontale Reflex-Tastschranke bezeichnet.

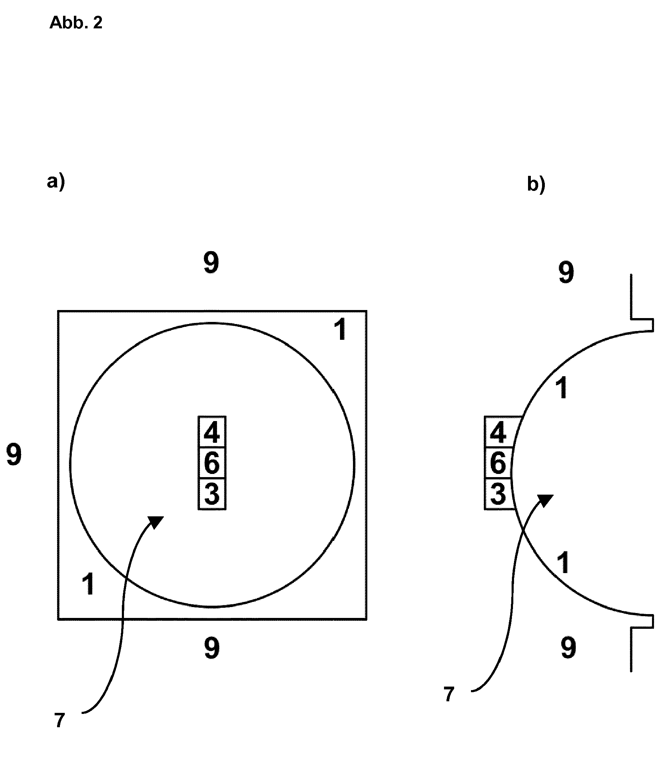

Abb. 2 zeigt eine schematische Ansicht einer bevorzugten Eingabevorrichtung umfassend eine einzelne Taste (7) mit einer frontalen Reflex-Tastschranke, welche vertieft in einer Wand (9) vorliegt. Das Detektionsprinzip erfolgt wie für die bevorzugte Ausführungsform gemäß Abb. 1. Das Paar aus Sender (4) und Empfänger (6) liegt nebeneinander in der Wand (9) installiert vor, wobei die Installation vertieft erfolgt. Hierdurch wird die Sensorik auf besonders effektive Weise geschützt. Weiterhin erlaubt die Vertiefung eine besonders benutzerfreundliche Bedienung. Der Detektionsabstand der frontalen Reflex-Tastschranke kann so gewählt werden, dass eine Hand bevorzugt der Finger in die Vertiefung bevorzugt eintauchen sollte, um die Taste berührungslos zu aktivieren. Die Taste (7) wird somit visuell deutlich erkennbar durch die Vertiefung in der Wand (9) angezeigt. Vorteilhafterweise kann ein Nutzer wie bei der Handhabung von herkömmlichen Tasten eine Drückbewegung mit dem Finger in die Vertiefung zur Eingabe vollziehen, ohne jedoch eine kontaktbehaftete Übertragung von Keimen oder Schmutz zu riskieren. Die Kontroll-LED (3) zeigt wiederum bevorzugt den Betriebszustand der Taste (7) an. Abb. 2a zeigt eine Draufsicht und Abb. 2b eine Schnittansicht der Eingabevorrichtung.

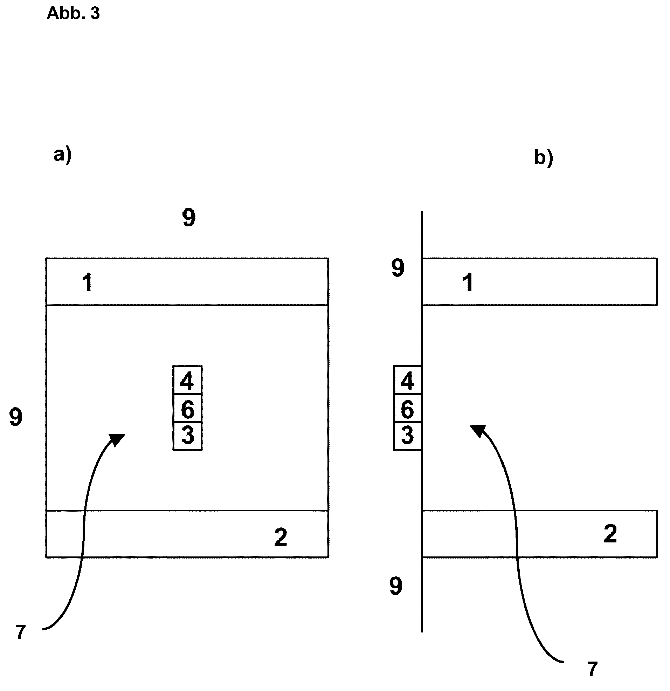

Abb. 3 zeigt eine bevorzugte Ausführungsform der Eingabevorrichtung mit einer einzelnen Taste (7), welche durch einer frontalen Reflex-Tastschranke berührungslos bedient werden kann. Das Detektionsprinzip erfolgt wie für die bevorzugte Ausführungsform gemäß Abb. 1, wobei das Paar aus Sender (4) und Empfänger (6) nebeneinander in der Wand installiert vorliegen. In der bevorzugten Ausführungsform gemäß Abb. 3, wird die Taste jedoch durch die Halterungen 1 und 2 begrenzt. Diese dienen sowohl der besseren Visualisierung, an welcher Position ein Finger eingeführt werden sollte, um die Taste (7) berührungslos zu bedienen. Weiterhin erlaubt der durch die Halterungen (1) und (2) gebildete Rahmen einen Schutz der Sensorik. Die Kontroll-LED (3) zeigt bevorzugt den Betriebszustand der Taste (7) an. Abb. 3a zeigt eine Draufsicht und Abb. 3b eine Schnittansicht der bevorzugten Ausführungsform der Eingabevorrichtung.

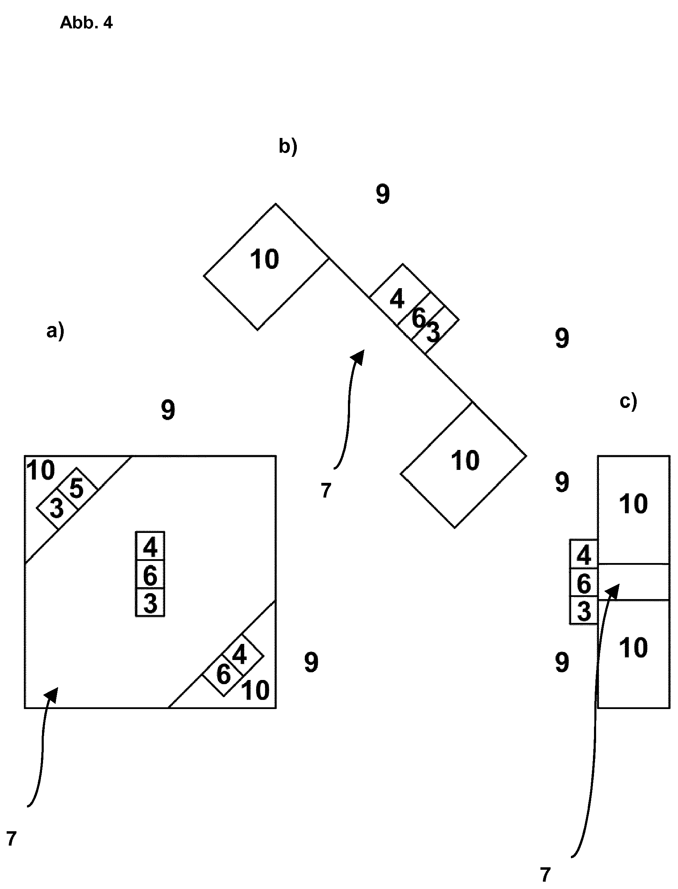

Abb. 4 zeigt eine bevorzugte Ausführungsform der Eingabevorrichtung mit einer einzelnen Taste (7), welche durch eine frontale Reflex-Tastschranke berührungslos bedient werden kann. Das Detektionsprinzip erfolgt wie für die bevorzugte Ausführungsform gemäß Abb. 1, wobei das Paar aus Sender (4) und Empfänger (6) nebeneinander in der Wand (9) installiert vorliegt. Wie in Abb. 3 wird die Sensorik aus Sender (4) und Empfänger (6) von einem Rahmen (10) begrenzt, welcher an der Wand (9) installiert vorliegt. Im Gegensatz zu Abb. 3 ist der Rahmen (10) jedoch diagonal zu Anordnung des Sender-Empfänger-Paares (4,6) und der Kontroll-LED (3) angeordnet. Weiterhin können durch weitere Sender (4) und Empfänger (5,6) in dem Rahmen zusätzliche Durchgangs- oder Reflex-Tastschranken gebildet werden. Die Kontroll-LED (3) zeigt bevorzugt den Betriebszustand der Taste (7) an. Abb. 4a zeigt eine Draufsicht, Abb. 4b eine Schnittansicht über die Diagonale des Rahmens (10) und Abb. 4c eine Schnittansicht parallel zur Wand (9).

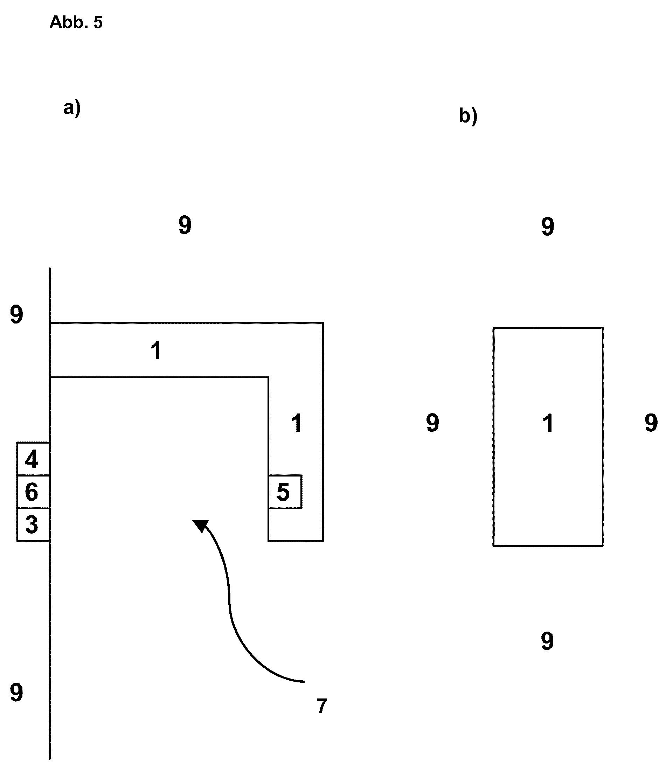

Abb. 5 zeigt eine bevorzugte Eingabevorrichtung umfassend eine einzelne Taste (7) mit einer Detektionsschranke, wobei der Empfänger (5) in einer Halterung (1) installiert vorliegt, welche hakenförmig ausgebildet ist und an einer Wand (9) installiert vorliegt. Hierdurch kann vorteilhafterweise eine Durchgangsschranke gebildet werden, wobei der Sender (4) und der Empfänger (5) auf gegenüberliegenden Seiten der Taste (7) angeordnet vorliegen. Bei Einführung einer Hand bevorzugt eines Fingers in die Durchgangsschranke zwischen den Sender (6) und den Empfänger (5) kann an dem Empfänger (5) eine Abnahme des Signales festgestellt werden. Hierdurch wird angezeigt, dass durch die Positionierung des Fingers eine berührungslose Bedienung der Taste (7) erfolgen soll. Zur Anzeige des Betriebszustandes der Eingabevorrichtung kann eine Kontroll-LED (3) eingesetzt werden. Weiterhin kann es bevorzugt sein, dass zusätzlich oder alternativ zur Durchgangsschranke eine Reflex-Tastschranke eingesetzt wird. Hierzu wird ein weiterer Empfänger (6) neben dem Sender (4) installiert. Abbildung 5a zeigt eine Schnittansicht parallel zur Wand (9) und Abb. 5b die Draufsicht auf die bevorzugte Eingabevorrichtung.

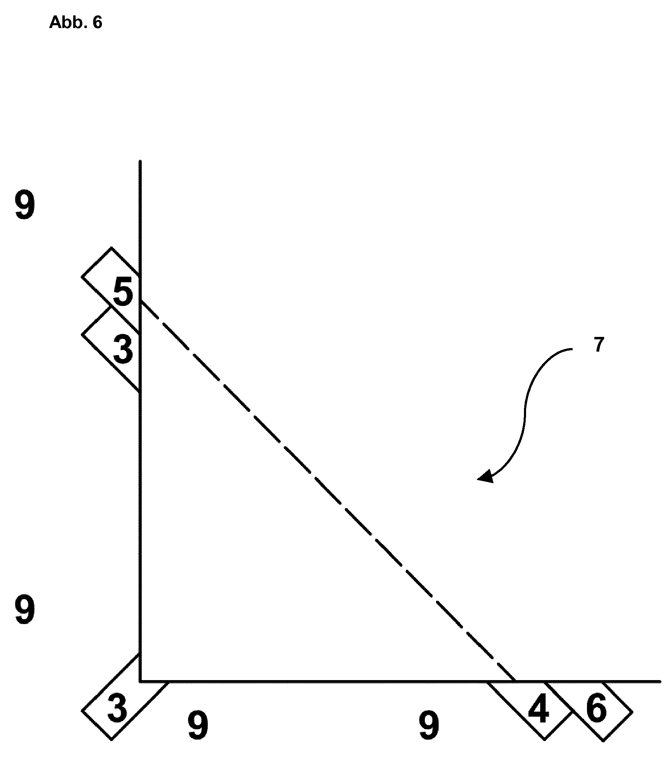

Abb. 6 zeigt die Schnittansicht einer bevorzugten Eingabevorrichtung mit einer Detektionsschranke, welche in der Ecke einer Wand (9) installiert vorliegt. Hierzu kann eine Durchgangsschranke mithilfe eines Senders (4) und eines Empfängers (5) gebildet werden. Die gestrichelte Linie deutet den Strahlengang der Detektionsschranke an. Bei Einführung einer Hand bevorzugt eines Fingers in den Strahlengang erfolgt, wie für Abb. 5 beschrieben, eine Registrierung der Tastenbedienung aufgrund eines abnehmenden Signales am Empfänger. Der Betriebszustand wird bevorzugt durch eine Kontroll-LED (3) angezeigt. Es kann bevorzugt sein, dass zusätzlich oder alternativ zu dem durch das Sender-Empfänger-Paar (4, 6) gebildeten Durchgangsschranke eine Reflex-Tastschranke zum Einsatz kommt. Hierzu wird bevorzugt neben dem Sender (4) ein weiterer Empfänger (6) installiert.

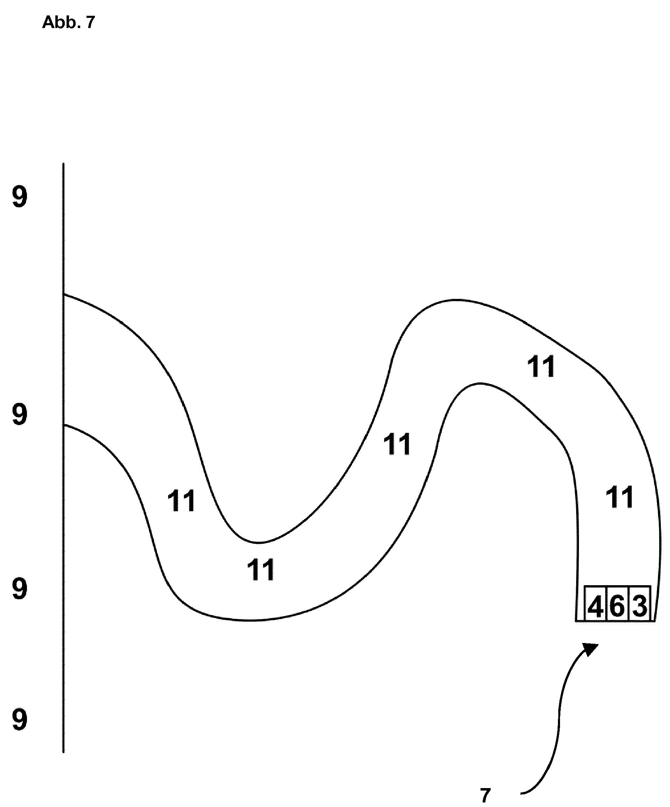

Abb. 7 zeigt die schematische Ansicht einer bevorzugten Eingabevorrichtung umfassend eine justierbare Halterung (11) zur Aufnahme des Sender-Empfänger-Paares (4,6) durch Verwendung eines flexiblen Schlauches. Hierzu wird bevorzugt ein flexibler Arm als Halterung (11) in einer Wand (9) installiert. Die Sensorik, d.h. das Paar aus Sender (4) und Empfänger (6) sowie bevorzugt eine Kontroll-LED (3) werden in den frontalen Abschnitt des flexiblen Armes (11) eingebracht. Hierdurch wird eine frontale Reflex-Tastschranke mit einem Detektionsprinzip wie für Abb. 1 beschrieben umgesetzt. Vorteilhafterweise ist es jedoch möglich die berührungslose Taste (7) frei im Raum zu positionieren, wodurch eine besonders flexible Verwendung der berührungslosen Tastschranken ermöglicht wird.

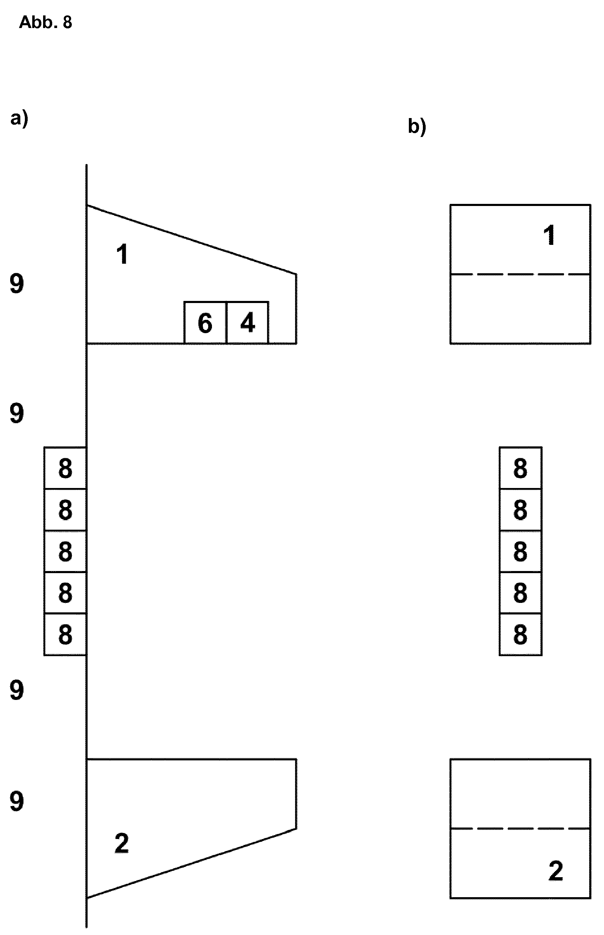

Abb. 8 zeigt eine schematische Ansicht einer bevorzugten Eingabevorrichtung mit einer Reihe von Tasten (8) und einer Reflex-Tastschranke, welche basierend auf einer Entfernungsmessung die berührungslose Bedienung der einzelnen Tasten (8) erkennt. Bei der bevorzugten Ausführungsform liegt ein Tastenfeld mit fünf Tasten (8) vor, welche in einer Reihe angeordnet innerhalb oder an einer Wand (9) installiert werden. Der Betriebszustand der Tasten (8) wird bevorzugt durch ein Kontroll-LED angezeigt. Zur vereinfachten schematischen Darstellung wird daher die Taste (8) mit dem Bezugszeichen (8) versehen. Dies umfasst somit sowohl eine visuelle Markierung unter Kennzeichnung der Taste (8) durch zum Beispiel einen Rahmen oder aber durch das Vorhandensein der Kontroll-LED. In Anlehnung an die Bezugszeichen in Abb. 1-7 könnte die Taste mit Kontroll-LED (Bezugszeichen 8) auch mit zwei separaten Bezugszeichen 7 und 3 bezeichnet werden. Das Tastenfeld wird mit Hilfe einer Reflex Tastschranke überwacht, welche in der Lage ist durch eine Entfernungsmessung zu detektieren, über welche der fünf Tasten (8) eine Hand bevorzugt ein Finger positioniert wird. Hierzu wird ein Paar aus Sender (4) und Empfänger (6) in einer Halterung (1) an der Wand (9) installiert, sodass der Strahlengang parallel zur Tastenoberfläche vor den Tasten (8) erfolgt. Die gegenüberliegende Halterung (2) dient dem Schutze des Tastenfeldes und stellt zum anderen eine parallele Reflexionsfläche dar. Solange ein Objekt oder Finger in der Reflex-Tastschranke eingebracht wird, erfolgt eine konstante Reflexion des vom Sender (4) ausgestrahlten Lichtes oder Ultraschalles, sodass für diesen Zustand eine konstante Entfernung detektiert wird. Wenn eine Hand bevorzugt ein Finger in die Detektionsschranke vor einer Taste (8) eingebracht wird, wird eine entsprechend kürzere Distanz festgestellt durch zum Beispiel eine Zeit- und/oder Intensitätsmessung des reflektierten Lichtes. Eine solche bevorzugte Eingabevorrichtung kann beispielsweise zur Bedienung eines Fahrstuhles eingesetzt werden. Abb. 8a zeigt eine Schnittdarstellung und Abb. 8b eine Draufsicht auf die bevorzugte Ausführungsform der Eingabevorrichtung.

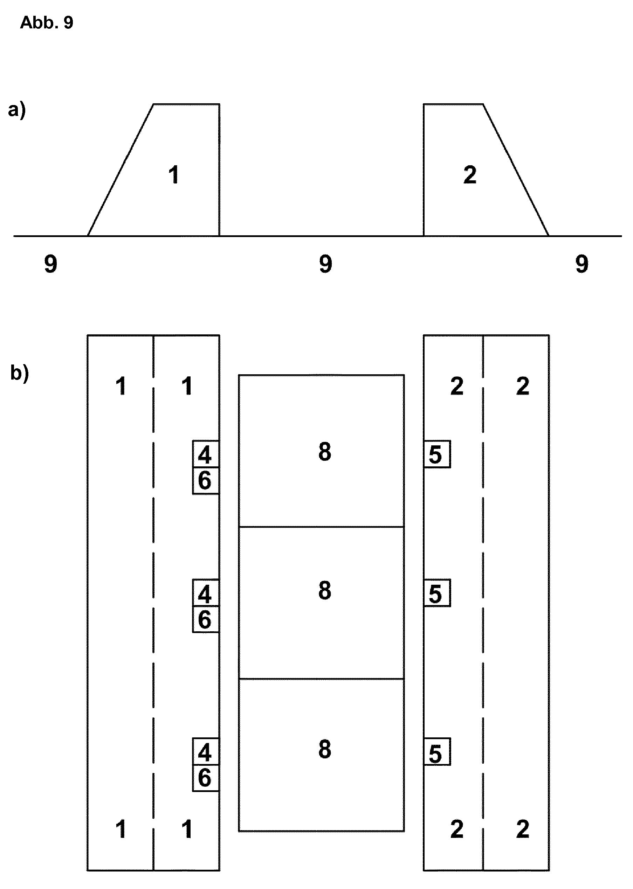

Abb. 9 zeigt eine schematische Ansicht einer bevorzugten Eingabevorrichtung umfassend ein Tastenfeld mit einer Reihe von Tasten (8), welche durch jeweils eine Durchgangsschranke überwacht werden. Abb. 9a zeigt eine Schnittansicht von oben oder unten und Abb. 9b die Draufsicht auf die bevorzugte Ausführungsform der Eingabevorrichtung. Die Halterungen (1) und (2) sind jeweils an der Wand (9) installiert und bilden einen seitlichen Rahmen zu der Reihe der drei Tasten (8), welche das Tastenfeld bilden. Die Überwachung der Positionierung einer Hand bevorzugt eines Fingers in Höhe der einzelnen Tasten (8) des Tastenfeldes erfolgt bevorzugt mithilfe von jeweils einer Durchgangsschranke pro Taste (8). Zu diesem Zweck ist ein Paar aus einem Sender (4) und einem Empfänger (5) jeweils auf den gegenüberliegenden Seiten der jeweiligen Tasten (8) in den seitlichen Halterungen (1) und (2) installiert. Das Prinzip der Detektion erfolgt wie für eine Durchgangsschranke geschildert auf Basis der Messung der Signaländerung am Empfänger (5), sobald ein Finger den Strahlengang durchbricht. Es kann aber auch bevorzugt sein, dass zusätzlich oder alternativ pro Taste (8) eine Reflex-Tastschranke eingesetzt wird. Hierzu wird bevorzugt ein weiterer Empfänger (6) neben dem Sender (4) installiert. Durch eine kombinierte Detektion mit Hilfe einer Durchgangsschranke und Reflex-Tastschranke ist eine besonders zuverlässige Auswertung möglich.

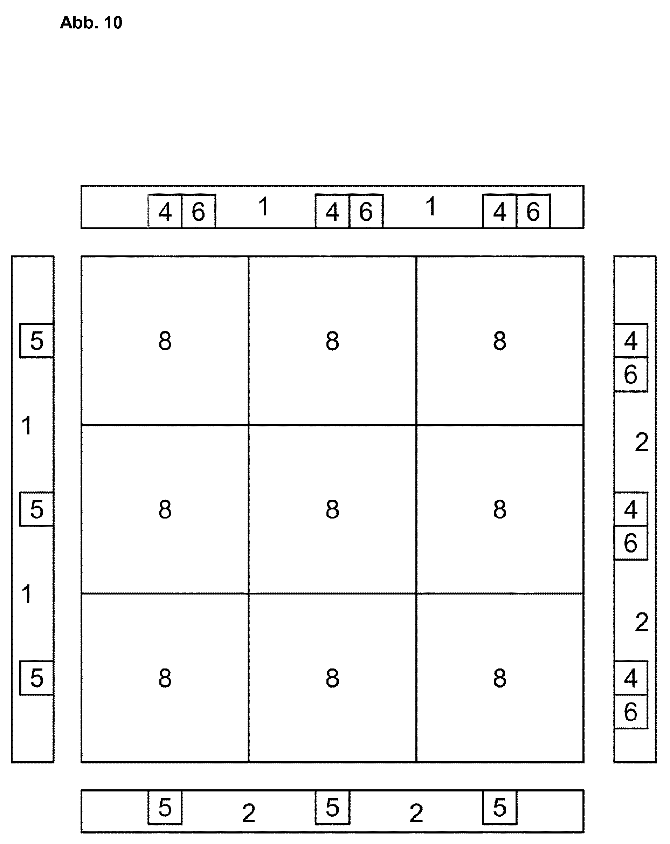

Abb. 10 zeigt eine bevorzugte Ausführungsform der Eingabevorrichtung zur berührungslosen Bedienung eines Tastenfeldes, welches aus einem Gitter von Tasten (8) besteht. In der schematischen Ansicht wird das Gitter von jeweils 3 × 3 Tasten (8) dargestellt. Die Überwachung erfolgt mit Hilfe von jeweils einer Durchgangsschranke für die drei Reihen und drei Spalten des Tastenfeldes. Insgesamt umfasst die bevorzugte Eingabevorrichtung somit bevorzugt sechs Durchgangsschranken, welche jeweils von einem Sender-Empfänger-Paar (4,5) gebildet werden und zu diesem Zweck auf gegenüberliegenden Seiten der Reihe oder Spalte der Tasten (8) angeordnet sind. Die Positionierung der Sender-Empfänger-Paar (4,5) wird durch Halterungen (1) und (2) realisiert, welche einen quadratischen Rahmen bilden. Eine Bestimmung, welche der Tasten (8) berührungslos aktiviert wird, erfolgt bevorzugt durch eine Korrelation der Auslösungssignale an den jeweiligen Durchgangsschranken, welche gleichzeitig oder in einem nahen zeitlichen Abstand die Positionierung eines Fingers detektieren. Sollte eine Hand bevorzugt ein Finger die untere, rechte Ecke des Tastenfeldes aktivieren, so kann die Positionierung anhand einer gleichzeitigen Signaldetektion der Detektionsschranken vor der dritten Reihe und dritten Spalte (jeweils von oben und links) festgestellt werden. Weiterhin kann es auch bevorzugt sein, dass neben den Durchgangsschranken durch das Hinzufügen eines weiteren Empfängers (6) neben jeweils dem Sender (4) eine Reflex-Tastschranke gebildet wird. Diese Reflex-Tastschranke sollte eine Entfernungsmessung erlauben, um eine positionsaufgelöste Detektion der Tasten (8) zu ermöglichen. Durch eine Korrelation sowohl der Signale der Durchgangsschranken, als auch der Reflex-Tastschranken, kann besonders zuverlässig die Positionierung eines Fingers vor den Tasten (8) erkannt werden.

Es wird darauf hingewiesen, dass verschiedene Alternativen zu den beschriebenen Ausführungsformen der Erfindung verwendet werden können, um die Erfindung auszuführen und zu der erfindungsgemäßen Lösung zu gelangen. Die erfindungsgemäße Eingabevorrichtung sowie deren Verwendung in den beschrieben Verfahren beschränken sich in ihren Ausführungen somit nicht auf die vorstehenden bevorzugten Ausführungsformen. Vielmehr ist eine Vielzahl von Ausgestaltungsvarianten denkbar, welche von der dargestellten Lösung abweichen können. Ziel der Ansprüche ist es, den Schutzumfang der Erfindung zu definieren. Der Schutzumfang der Ansprüche ist darauf gerichtet, die erfindungsgemäße Eingabevorrichtung und bevorzugte Verwendungen sowie äquivalente Ausführungsformen von diesen abzudecken.

### BEZUGSZEICHENLISTE

(**1**), (**2**) Halterung
(**3**) Kontroll-LED
(**4**) Sender (Ultraschall oder Infrarot-Licht)
(**5**) Empfänger zu (**4**) bei einer Durchgangsschranke
(**6**) Empfänger zu (**4**) bei Reflex-Tastschranke
(**7**) Taste eines Tastenfeldes
(**8**) Taste eines Tastenfeldes mit einer Kontroll-LED
(**9**) Wand
(**10**) Rahmen oder erhöhter Teil der Halterung bzw. Schutzbügel
(**11**) flexibler Arm als Halterung

## Patentansprüche

1. Eingabevorrichtung zur berührungslosen Bedienung eines Tastenfeldes umfassend eine Datenverarbeitungsvorrichtung, mindestens einen Sender (4) zur Ausstrahlung von Licht und/oder Ultraschall, mindestens einen Empfänger (5,6) zur Detektion von Licht- und/oder Ultraschall und ein Tastenfeld mit mindestens einer Taste (7,8)
**dadurch gekennzeichnet, dass**
das mindestens ein Paar aus Sender (4) und Empfänger (5,6) eine Detektionsschranke formt, wobei Daten der Sender (4) und Empfänger (5,6) durch die Datenverarbeitungsvorrichtung auswertbar sind, sodass anhand der Daten eine Positionierung einer Hand bevorzugt eines Fingers vor mindestens einer Taste (7,8) des Tastenfeldes bestimmbar ist.

2. Eingabevorrichtung gemäß einem der vorherigen Ansprüche
**dadurch gekennzeichnet, dass**
der mindestens eine Sender (4) ein Infrarotsender ist und der mindestens eine Empfänger (5,6) ein Fototransistor.

3. Eingabevorrichtung gemäß einem der vorherigen Ansprüche
**dadurch gekennzeichnet, dass**
der mindestens eine Sender (4) ein Ultraschallsender ist und der mindestens eine Empfänger (5,6) ein Ultraschalldetektor.

4. Eingabevorrichtung gemäß einem der vorherigen Ansprüche
**dadurch gekennzeichnet, dass**
die Eingabevorrichtung eine optische Anzeige (3), bevorzugt eine LED, umfasst, welche den Betätigungszustand der Taste (7,8) anzeigt.

5. Eingabevorrichtung gemäß einem der vorherigen Ansprüche
**dadurch gekennzeichnet, dass**
das mindestens ein Paar aus Sender (4) und Empfänger (6) in einer Taste (7,8) des Tastenfeldes nebeneinander angeordnet vorliegt und die Emission des Lichtes oder des Ultraschalls senkrecht zur Tastenoberfläche erfolgt, wobei bei einer Positionierung einer Hand bevorzugt eines Fingers vor der Taste (7,8) das vom Sender (4) emittierte Licht oder der vom Sender (4) emittierte Ultraschall zum Empfänger (6) zurückreflektiert wird, sodass das Paar aus Sender und Empfänger eine Reflex-Tastschranke bildet.

6. Eingabevorrichtung gemäß dem vorherigen Anspruch
**dadurch gekennzeichnet, dass**
die Reflex-Tastschranke eine senkrechte Positionierung einer Hand bevorzugt eines Fingers vor der Taste (7,8) unterhalb eines festgelegten Abstandes bevorzugt unterhalb von 5 cm detektiert.

7. Eingabevorrichtung gemäß einem der Ansprüche **1** - **4**
**dadurch gekennzeichnet, dass**
die Eingabevorrichtung mindestens eine Halterung (1, 2) zur Aufnahme des mindestens einen Senders (4) und mindestens einen Empfängers (6) umfasst, wobei das mindestens eine Paar aus Sender (4) und Empfänger (6) in der Halterung nebeneinander positioniert ist, sodass das Licht oder der Ultraschall von dem Sender (4) in einem Strahl parallel zur Oberfläche der mindestens eine Taste (7,8) mittig vor der mindestens eine Taste (7,8) abgestrahlt wird,
wobei bei einer Positionierung einer Hand bevorzugt eines Fingers vor der mindestens eine Taste (7,8) das vom Sender (4) abgestrahlte Licht oder der Ultraschall zum Empfänger (6) zurückreflektiert wird und die Datenverarbeitungsvorrichtung anhand der Daten die Entfernung der Hand bevorzugt des Fingers von dem mindestens einen Paar aus Sender (4) und Empfänger (6) messen kann,
sodass durch die gebildete Reflex-Tastschranke durch eine Entfernungsmessung eine Positionierung der Finger bevorzugt des Fingers vor der mindestens einen Taste (7,8) bestimmbar ist.

8. Eingabevorrichtung gemäß dem vorherigen Anspruch
**dadurch gekennzeichnet, dass**
das Tastenfeld mehrere Tasten (7,8) umfasst, welche in mindestens einer Reihe entlang der Orientierung mindestens einer Reflex-Tastschranke angeordnet vorliegen und durch die Entfernungsmessung mit Hilfe der Reflex-Tastschranke bestimmbar ist, vor welcher der mehreren Tasten (7,8) ein Finger positioniert wird.

9. Eingabevorrichtung gemäß dem vorherigen Anspruch
**dadurch gekennzeichnet, dass**
das Tastenfeld mehrere Tasten (7,8) umfasst, welche in mindestens zwei Reihen angeordnet vorliegen, wobei für jede der mindestens zwei Reihen jeweils ein Paar aus Sender (4) und Empfänger (6) eine Reflex-Tastschranke bilden, um auf Basis einer Entfernungsmessung die Positionierung eines Fingers vor genau einer Taste (7,8) des Tastenfeldes zu bestimmen.

10. Eingabevorrichtung gemäß einem der Ansprüche **1** - **4**
**dadurch gekennzeichnet, dass**
die Eingabevorrichtung mindestens eine Halterung (1,2) zur Aufnahme des mindestens einen Sender (4) und mindestens einen Empfänger (5) umfasst,
wobei das mindestens eine Paar aus Sender (4) und Empfänger (5) in der Halterung auf zwei gegenüberliegenden Seiten der mindestens einen Taste (7,8) des Tastenfeldes positioniert ist, sodass das Paar eine Durchgangsschranke bildet, wobei bei einer Positionierung einer Hand bevorzugt eines Fingers vor der mindestens eine Taste (7,8) der Strahl von Licht oder Ultraschall zwischen dem Sender (4) und Empfänger (5) blockiert wird,
sodass eine Positionierung der Hand bevorzugt des Fingers vor der mindestens einen Taste (7,8) detektiert werden kann.

11. Eingabevorrichtung gemäß dem vorherigen Anspruch
**dadurch gekennzeichnet, dass**
das Tastenfeld mehrere Tasten (7,8) umfasst, welche in mindestens einer Reihe angeordnet vorliegen, wobei Paare aus Sendern (4) und Empfängern (5) derart in einer Halterung (1,2) seitlich von der Reihe der Tasten positioniert werden, dass vor jeder Taste (7,8) eine Durchgangsschranke geformt wird, sodass anhand der Daten der Durchgangsschranken bestimmbar ist, vor welcher der mehreren Tasten (7,8) eine Hand bevorzugt ein Finger positioniert wird.

12. Eingabevorrichtung gemäß dem vorherigen Anspruch
**dadurch gekennzeichnet, dass**
das Tastenfeld mehrere Tasten (7,8) umfasst, welche in einem Gitter umfassend mindestens zwei Reihen und mindestens zwei Spalten angeordnet vorliegen,
wobei mindestens vier Paare von Sendern (4) und Empfängern (5) mindestens vier Durchgangsschranken formen, welche mittig vor den Reihen und Spalten des gitterförmigen Tastenfeldes verlaufen,
sodass aus der Korrelation der Daten der Durchgangsschranken bestimmbar ist, vor welcher der Tasten (7,8) des gitterförmigen Tastenfeldes eine Hand bevorzugt ein Finger positioniert wird.

13. Eingabevorrichtung gemäß einem der vorherigen Ansprüche
**dadurch gekennzeichnet, dass**
dass die Datenverarbeitungsvorrichtung einen Mikrocontroller und/oder eine integrierte Schaltung umfasst, sodass eine Ansteuerung entsprechender elektronischer Schalter oder Relais durchgeführt werden kann und Fehlauslösungen detektiert werden können.

14. Verwendung einer Eingabevorrichtung gemäß einem der vorherigen Ansprüche zur berührungslosen Bedienung einer Taste, eines Schalters, einer Klingeltaste, eines Fahrstuhles, eines Automaten insbesondere eines Automaten zur Ausgabe von Lebensmitteln oder eines Codeschlosses bevorzugt zur Authentifizierung eines Zuganges zu einem Raum oder einem Gebäude.
